# EUROPEAN PATENT APPLICATION

(11) **EP 3 007 524 A2**
(43) Date of publication of application: **13.04.2016**
(21) Application number: 15189102.5
(22) Date of filing: 09.10.2015
(51) Int. Cl.: H05K 1/18, H05K 3/32

(54) **ARRANGEMENT AND METHOD FOR CONNECTING ELECTRONIC COMPONENTS TO A TERMINAL FOR A SENSOR ASSEMBLY**

(30) Priority: 09.10.2014 US 201462061855 P; 08.10.2015 US 201514878457
(71) Applicant: Continental Automotive Systems, Inc., Auburn Hills, MI 48326 (US)
(72) Inventor: VICH, Gaetan, Clarkston, MI Michigan 48348 (US)
(74) Representative: Isarpatent

(57) **Abstract**

A sensor assembly comprises an electronic component portion, wherein the electronic component is a metal electrode leadless face style component and a terminal portion, wherein the terminal portion defines a through hole and the electronic component portion is received within the through hole. The electronic component portion has a press fit with the terminal portion to retain the electronic component portion to the terminal portion.

## Description

### CROSS REFERENCE TO RELATED APPLICATION

This application claims priority to United States Provisional Application No. 62/061,855 filed on October 9, 2014.

### TECHNICAL FIELD

The present disclosure relates to automotive vehicles and more particularly to sensors and components which are connected to leadframes for automotive vehicles.

### BACKGROUND

Automotive vehicles use many different types of sensors with components, which need be mounted to a leadframe or a PCB for a component of the vehicle. Typically, the lead portions of the sensors are secured to the leadframe or PCB by soldering or welding.

The background description provided herein is for the purpose of generally presenting the context of the disclosure. Work of the presently named inventors, to the extent it is described in this background section, as well as aspects of the description that may not otherwise qualify as prior art at the time of filing, are neither expressly nor impliedly admitted as prior art against the present disclosure.

### SUMMARY

A sensor assembly comprises an electronic component portion, wherein the electronic component portion is a metal electrode leadless face style component and a terminal portion, wherein the terminal portion defines a through hole and the electronic component portion is received within the through hole. The electronic component portion has a press fit with the terminal portion to retain the electronic component portion to the terminal portion.

A method of assembling a sensor assembly comprises forming a through hole in a terminal portion and pressing a electronic component portion into the through hole defined by the terminal portion, wherein the electronic component portion has a press fit with the terminal portion, and wherein the electronic component portion is a metal electrode leadless face style component.

Further areas of applicability of the present disclosure will become apparent from the detailed description provided hereinafter. It should be understood that the detailed description and specific examples, while indicating the preferred embodiment of the disclosure, are intended for purposes of illustration only and are not intended to limit the scope of the disclosure.

### BRIEF DESCRIPTION OF THE DRAWINGS

The present disclosure will become more fully understood from the detailed description and the accompanying drawings, wherein:
FIG. 1 is a schematic illustration of a first embodiment of the present invention of an arrangement for securing a MELF resistor to a leadframe;
FIG. 2 is a terminal schematic illustration of the electronic component embodiment of the arrangement for securing the MELF resistor to the leadframe of Fig. 1;
FIG. 3 is a third schematic illustration of the electronic component embodiment of the arrangement for securing the MELF resistor to the leadframe of Figs. 1-2;
FIG. 4 is a schematic illustration of a terminal embodiment of the present invention of an arrangement for securing a MELF resistor to a leadframe;
FIG. 5 is a schematic illustration of a third embodiment of the present invention of an arrangement for securing a MELF resistor to a leadframe;
FIG. 6 is a schematic illustration of a fourth embodiment of the present invention of an arrangement for securing a MELF resistor to a leadframe;
FIG. 7 is a schematic illustration of a fifth embodiment of the present invention of an arrangement for securing a MELF resistor to a leadframe; and
FIG. 8 is a schematic illustration of a sixth embodiment of the present invention of an arrangement for securing a MELF resistor to a leadframe.

### DETAILED DESCRIPTION

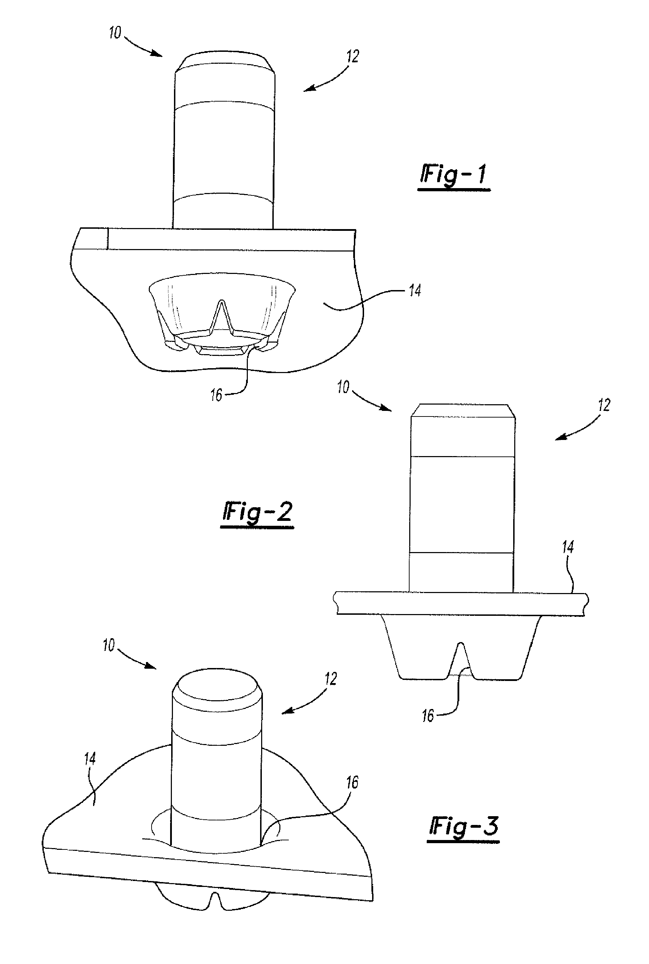

The following description is merely exemplary in nature and is in no way intended to limit the disclosure, its application, or uses. For purposes of clarity, the same reference numbers will be used in the drawings to identify similar elements. Figures 1-3 illustrate a sensor assembly 10, preferably for an automotive vehicle. The assembly 10 includes an electronic component portion 12 and a terminal portion 14. The electronic component portion 12 may be any type of electronic component, such as a MELF (metal electrode leadless face) resistor or diode. The terminal portion 14 may be any type of component which the electronic component portion 12 needs to be secured, such as a leadframe or a PCB (printed circuit board). For example, the electronic component portion 12 may be a MELF resistor sometimes used in engine speed sensors 10.

A receiving location 16 is defined by the terminal portion 14. The receiving location 16 may be a through hole formed by punching or pierced in the terminal portion 14, or integrally formed when the terminal portion 14 is made. Alternately, the receiving location 16 may be a marked location on the terminal portion 14, or an area where the material of the terminal portion 14 is thinner for easier deformation. Only a portion of the terminal portion 14 is shown, however, there may be multiple receiving locations 16 located on one component 14.

The electronic component portion 12 is assembled to the terminal portion by pressing the electronic component portion 12 into the receiving location 16. The pressing operation for assembling the electronic component portion 12 to the terminal portion 14 is faster and uses less material than the welding or soldering process of securing the electronic component portion 12 to the leadframe 14. Additionally, the MELF style resistors or diodes are less expensive than leaded sensors.

When the receiving location 16 is a through hole, the hole is preferably the size and geometry as is needed to provide a desired fit for a particular electrical component 12. The electrical component 12 has a press fit or interference fit with the terminal portion 14. Excess material 18 is deformed when the electrical component 12 is pressed into the receiving location 16.

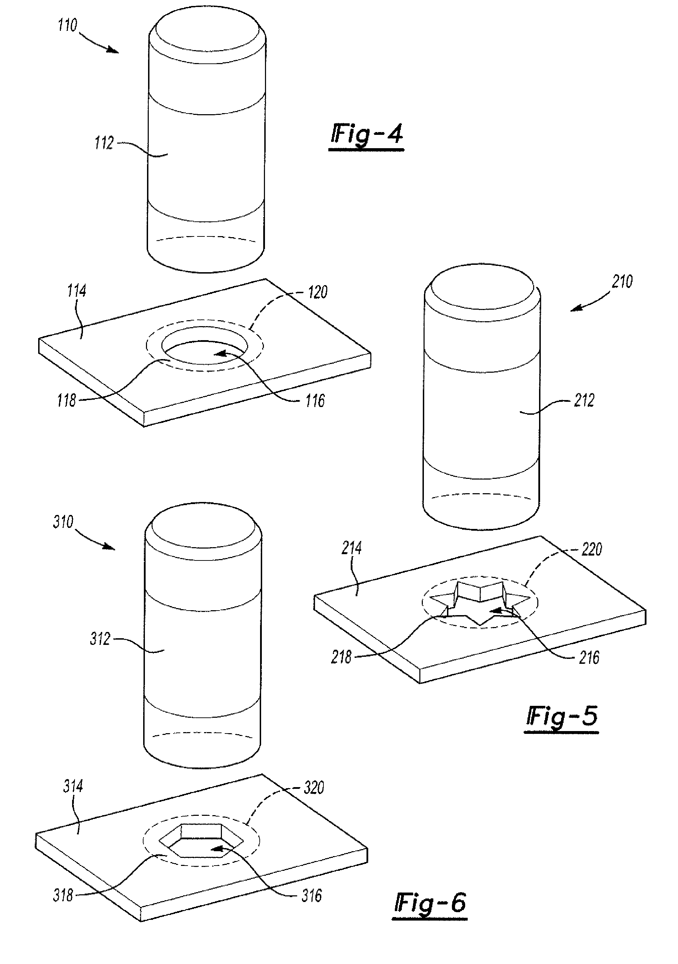

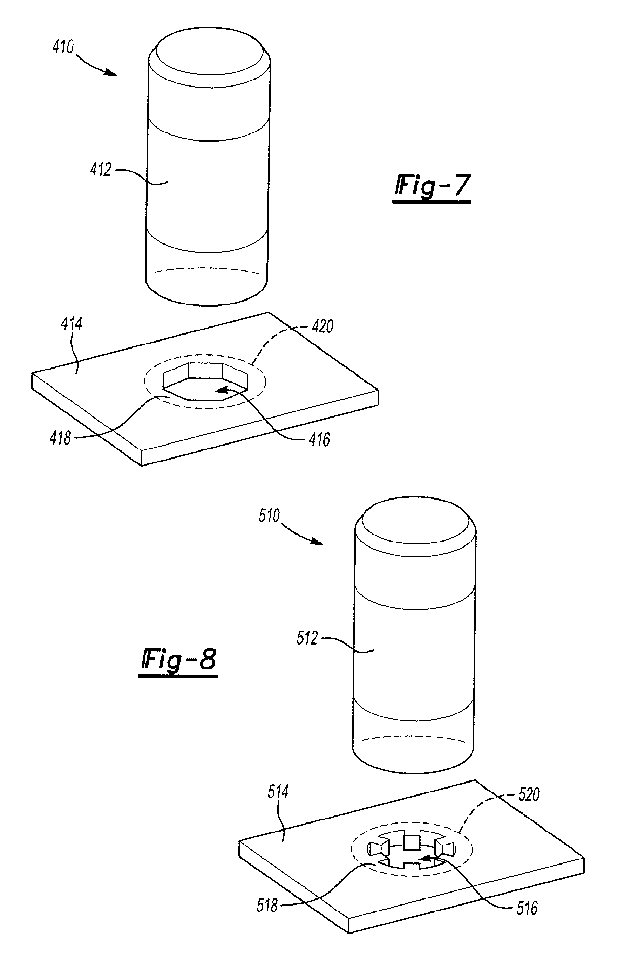

Referring to Figures 4-8 several embodiments of automotive component assemblies 110, 210, 310, 410, 510 are shown prior to pressing the electronic component portion 112, 212, 312, 412, 512 into the terminal portion 114, 214, 314, 414, 514. As illustrated the terminal portion 114, 214, 314, 414, 514 defines at least one receiving location 116, 216, 316, 416, 516. As discussed above, when the electrical component 112, 212, 312, 412, 512 is pressed into the terminal portion 114, 214, 314, 414, 514 excess material 118, 218, 318, 418, 518 is deformed by the electrical component 112, 212, 312, 412, 512. Phantom line 120, 220, 320, 420, 520 illustrates the approximate size and location of the material that will be deformed by the electrical component 112, 212, 312, 412, 512. As shown, the shape of the receiving location 116, 216, 316, 416, 516, and the shape and amount of excess material 118, 218, 318, 418, 518 may vary depending on a particular electrical component 112, 212, 312, 412, 512 and terminal portion 114, 214, 314, 414, 514 combination. One skilled in the art would be able to determine the desired shape of the receiving location 116, 216, 316, 416, 516, and the shape and amount of excess material 118, 218, 318, 418, 518 for a particular sensor assembly 110, 210, 310, 410, 510 and application of that assembly.

Additionally, when assembled the electrical component 112, 212, 312, 412, 512 may not be exactly centered to the receiving location 116, 216, 316, 416, 516. Pressing the electronic component portion 112, 212, 312, 412, 512 into the receiving location 116, 216, 316, 416, 516 should created sufficient contact with the excess material 118, 218, 318, 418, 518 to provide an electrical connection between the electronic component portion 112, 212, 312, 412, 512 and the terminal portion 114, 214, 314, 414, 514.

While the best modes for carrying out the invention have been described in detail the true scope of the disclosure should not be so limited, since those familiar with the art to which this invention relates will recognize various alternative designs and embodiments for practicing the invention within the scope of the appended claims.

## Claims

1. A sensor assembly comprising:
a electronic component portion, wherein the electronic component portion is a metal electrode leadless face style component;
a terminal portion, wherein the terminal portion defines a through hole and the electronic component portion is received within the through hole; and
wherein the electronic component portion has a press fit with the terminal portion to retain the electronic component portion to the terminal portion.

2. The sensor assembly of claim 1, wherein the terminal portion is a leadframe.

3. The sensor assembly of claim 1, wherein the terminal portion is a printed circuit board.

4. The sensor assembly of one of the claims 1-3, wherein the electronic component portion is a MELF resistor.

5. The sensor assembly of one of the claims 1-4, wherein the sensor assembly is an engine speed sensor.

6. A method of assembling sensor assembly comprising:
forming a through hole in a terminal portion of the sensor assembly; and
pressing an electronic component portion into the through hole defined by the terminal portion, wherein the electronic component portion has a press fit with the terminal portion, and wherein the electronic component portion is a metal electrode leadless face style component.

7. The method of claim 6, wherein the terminal portion is a leadframe.

8. The method of claim 6, wherein the terminal portion is a printed circuit board.

9. The method of one of the claims 6-8, wherein the electronic component portion portion is a MELF resistor.

10. The method of one of the claims 6-9, wherein the sensor assembly is an engine speed sensors.

11. The method of one of the claims 6-10, wherein forming the hole further comprises one of punching and piercing the hole in the terminal portion.
